# EUROPÄISCHE PATENTSCHRIFT

(11) **EP 2 179 632 B1**
(45) Veröffentlichungstag und Bekanntmachung des Hinweises auf die Patenterteilung: **17.11.2010**
(21) Anmeldenummer: 08773732.6
(22) Anmeldetag: 30.06.2008
(51) Int. Cl.: H05K 1/09, H05K 3/24, H01L 33/00, G09F 9/33, H05K 1/03

(54) **SUBSTRAT MIT EINER HOCHLEITFÄHIGEN SCHICHT**
SUBSTRATE COMPRISING A HIGHLY CONDUCTIVE LAYER
SUBSTRAT COMPRENANT UNE COUCHE HAUTEMENT CONDUCTRICE

(30) Priorität: 03.07.2007 DE 102007030923; 03.07.2007 US 947794 P; 06.07.2007 DE 102007031642; 06.07.2007 DE 102007031641; 19.02.2008 DE 102008009775
(43) Veröffentlichungstag der Anmeldung: 28.04.2010
(73) Patentinhaber: Schott AG, 55122 Mainz (DE)
(72) Erfinder: NICKUT, Andreas, 31073 Delligsen (DE); ALBRECHT, Bernd, 31073 Delligsen (DE); DOEPPNER, Christoph, Lothar, 36124 Eichenzell-Luetter (DE); MOEHL, Wolfgang, 67550 Worms (DE); SCHILLERT, Horst, 31073 Grünenplan (DE); KRACHT, Peter, 37603 Holzminden (DE); SCHNEIDER, Rolf, A., O., 72108 Rottenburg a.N. (DE); HENN, Christian, 55546 Frei-Laubersheim (DE); GRIMM, Daniel, 55271 Stadecken-Elsheim (DE); ANTON, Matthias, 37574 Einbeck (DE); WALTHER, Marten, 31061 Ahlfeld (DE); ULLMANN, Angelika, 31863 Coppenbrügge (DE); DUESING, Ernst-Friedrich, 31061 Ahlfeld (DE)
(74) Vertreter: Sawodny, Michael-Wolfgang
(86) Internationale Anmeldenummer: PCT/EP2008/005274
(87) Internationale Veröffentlichungsnummer: WO 2009/003652

(56) Entgegenhaltungen:
- DE-A1- 10 019 888
- US-A- 5 798 811
- US-A1- 2003 170 437
- US-A1- 2006 275 599

## Beschreibung

Die Erfindung betrifft ein Substrat mit einer hochleitfähigen Schicht.

Substrate mit leitfähigen Schichten, insbesondere transparente Substrate mit derartigen Schichten, wie sie beispielsweise für Bauelemente verwendet werden, bei denen derartige leitfähige Schichten als Zu- oder Steuerleitungen für Leuchtmittel verwendet werden, sind aus einer Vielzahl von Anmeldungen bekannt geworden. So beschreibt beispielsweise die EP 1450416 ein transparentes Substrat mit darauf aufgebrachten leitfähigen Schichten, wobei die leitfähigen Schichten im sichtbaren Wellenlängenbereich transparent oder semi transparent und beliebig strukturierbar sind. Die transparenten Schichten dienen als Leistungs- oder Steuerleitungen für wenigstens ein Leuchtmittel, das auf die Fläche des transparenten Substrates aufgebracht ist. Die aus der EP 1450416 A1 für derartige Anordnung bekannte Schichten sind insbesondere Schichten aus einem Metalloxid, beispielsweise aus ITO.

Nachteilig an den aus der EP 1450416 A1 bekannten leitfähigen Schichten ist, dass sie einen hohen Widerstand aufweisen, insbesondere einen Schichtwiderstand der größer ist als 16, insbesondere 20 Ohms/square.

Schichten mit einem derartig niedrigen Leitwert bzw. hohen Widerstand haben den Nachteil, dass bei entsprechender Leistungsaufnahme, sich die Schichten erwärmen. Dies führt zur Verfärbungen der Schicht, was insbesondere bei einem transparenten Display unerwünscht ist und sogar zu einer Ablösung der leitfähigen Schichten vom transparenten Substrat führen kann. Insbesondere bei Vorrichtungen, bei denen eine Vielzahl von LED's, beispielsweise mehr als 1000 oder sogar bis zu einer Million LED's mit Strom versorgt werden müssen, sind derartige Schichten nur schlecht geeignet.

Aufgabe der Erfindung ist es somit, ein transparentes Substrat anzugeben, dass die Nachteile des Standes der Technik, insbesondere Ablösung der leitfähigen Schichten vom transparenten Substrat und Verfärbungen vermeidet.

Erfindungsgemäß wird dies durch ein Substrat gemäß Anspruch 1.

Bevorzugt ist es, wenn die hoch leitfähigen Schichten eine Schichtdicke aufweisen, die größer oder gleich 150 nm ist, bevorzugt ≥ 180 nm, insbesondere bevorzugt ≥ 280 nm, insbesondere bevorzugt ≥ 500 nm, ganz besonders bevorzugt ≥ 550 nm und insbesondere ≥ 1000 nm aufweist.

Bevorzugt weisen die hochleitfähigen Schichten gemäß der Erfindung eine Transmission im sichtbaren Bereich, insbesondere bei einer Wellenlänge von ungefähr 550 nm auf, die zwischen 10 % und 99 % liegt, insbesondere im Bereich zwischen 70 % und 99 %, besonders bevorzugt im Bereich 80 % bis 99 %.

Besonders gute Leitfähigkeit und Reflektivitäten werden erreicht, wenn die hochleitfähige Schicht zusätzlich mit einer Metallschicht oder mit mehreren Metallschichten beschichtet wird. Überraschenderweise führen derartige auf- oder unter die hochleitfähige Schicht aufgebrachte Metallschicht zu einer erhöhten Reflektivität. Besonders bevorzugt ist es, wenn die Metallschicht ein Mehrfachschichtsystem, beispielsweise ein Dreischichtsystem Cr/Ag/Cr ist.

Die zusätzlich aufgedampfte Metallschicht hat bevorzugt eine Schichtdicke im Bereich 2 bis 100 nm, bevorzugt zwischen 5 und 60 nm. Die Schichtdicken der hochleitfähigen Schichten sind dagegen deutlich dicker.

Eine ganz besonders bevorzugt hochleitfähige Schicht ist eine hochleitfähiges Schichtsystem, das auf einem transparenten Substrat folgenden Aufbau hat:
transparentes Substrat / TiO₂ / SnO₂ : F,
d.h. zwischen transparentem Substrat und der fluordotierten Zinnoxidschicht wird eine TiO₂ - Zwischenschicht eingebracht. Ein derartiges System zeichnet sich durch einen Leitfähigkeit im Bereich von 3 bis 6·10 ⁻⁴ Ohm·cm, insbesondere 5 bis 5,5 ·10 ⁻⁴ Ohm·cm (Ω·cm) der SnO₂ : F -Schicht aus. Bei einer Schichtdicke von 550 nm der SnO₂ : F -Schicht ergibt sich dann ein Flächenwiderstand R_{□} im Bereich von 5 bis 11 Ohms/square, insbesondere 9 bis 10 Ohms/square (ohms/□) der SnO₂ : F -Schicht.

Bei einem hochleitenden Schichtsystem mit dem Aufbau:
transparentes Substrat / TiO₂ / SnO₂ : F
liegt bevorzugt die Schichtdicke für die TiO₂-Schicht im Bereich 5 nm bis 50 nm, bevorzugt im Bereich 10 nm bis 30 nm und die Schichtdicke der SnO₂ : F-Schicht im Bereich 200 nm bis 2000 nm, insbesondere im Bereich 500 nm bis 600 nm. Bei einem derartigen Schichtsystem können Leitfähigkeiten der SnO₂: F -Schicht im Bereich 3 bis 6 ·10⁻⁴ Ohm·cm, insbesondere 5 bis 5,5·10⁻⁴ Ohm·cm (Ω·cm) erreicht werden.

Der Grund für die hohe Leitfähigkeit dieses Schichtsystemes liegt unter anderem daran, dass auf dem TiO₂ das SnO₂:F Schichtsystem mit gröberer Morphologie aufwächst. Verantwortlich dafür ist das TiO₂, welches nicht amorph wie z.B. SiO₂ auf das Substrat aufwächst, sondern in kristalliner Form vorliegt, mit hoher Wahrscheinlichkeit in der anatasen Phase. Das Aufbringen des Schichtsystems auf das Substrat kann mittels APCVD Verfahren bei Temperaturen von größer 500° C erfolgen, was zu einer anatasen Phase des TiO₂ führt. Durch die gröbere Struktur der SnO₂:F-Schicht ändern sich deren elektrischen Eigenschaften. Insbesondere werden in der SnO₂:F-Schicht die mittlere freie Weglänge und die Ladungsträgerkonzentration beeinflusst. Durch diese Effekte kann eine Verbesserung der Leitfähigkeit erzielt werden.

Bevorzugt finden die hochleitfähigen Schichten, die auf dem Substrat aufgebracht sind, im Bereich von großflächigen Anzeigen Verwendung. Die hochleitfähigen Schichten erlauben bei großflächigen Anzeigen, bei denen beispielsweise bis zu 1000 Leuchtmittel über eine Sammelschiene versorgt werden können bzw. bis zu 1000 Leuchtmittel auf dem transparenten Substrat mit einer Ansteuerelektronik verbunden werden, die Ausgestaltung sehr schmaler Leiterbahnen, so dass optisch eine besondere dichte Packung der Leuchtdioden realisiert werden kann, ohne dass sich die Leiterbahnen unmäßig erwärmen.

Neben einer Verwendung der hochleitfähigen Schichten für die Ansteuerung von Verbrauchern, beispielsweise Leuchtdioden, Leuchtdiodenstrahlern- oder Lautsprechern können die hochleitfähigen Schichten auch als Signal übertragende Schichten verwendet werden.

Ein transparentes Substrat mit einer derartig hochleitenden Schicht kann dann auch als Signal übertragendes Glas verwendet werden, insbesondere im Bereich der Sensortechnik. Beispielsweise wäre es dann möglich, ein auf der Glasfläche schaltbares Glas zu realisieren, wie beispielsweise eine Glastastatur.

Besonderes bevorzugt ist die Verwendung der hochleitfähigen Schichten als Leiterbahnen zu einem Leuchtmittel, beispielsweise im Bereich des Großflächendisplays mit mehr als 10 qm², bevorzugt mehr als 100 qm², insbesondere mehr als 1000 qm² Anzeigefläche. Bevorzugt sind bei einem derartigen Großflächendisplay die Leuchtmittel, Leuchtdioden, beispielsweise sog. RGB-Leuchtdioden oder RGB-Leuchtdiodenchips, die dazu geeignet sind, farbige Bilder beispielsweise Fernsehbilder mit entsprechender Ansteuerung zu projizieren. Neben der Stromversorgung der Leuchtmittel mit Hilfe der hochleitfähigen Bahnen bei einem transparenten Substrat in einer Großflächenanzeigenvorrichtung ist auch die Steuerung der jeweiligen Leuchtmittel möglich. In einer besonderen Ausführungsform ist das transparente Substrat ein Glassubstrat. In einer fortgebildeten Ausführungsform verfügt das transparente Substrat über Anschlüsse für die Stromversorgung für die hochleitfähigen Schichten. Die Leuchtmittel sind bevorzugt sog. RGB-Leuchtdioden, die mit Hilfe von Ansteuerungen beliebige Bilder erzeugen können. Für eine derartige Anwendung ist besonders bevorzugt, wenn die hochleitfähigen Schichten auf dem transparenten Substrat mehrere Stromkreise zur Stromversorgung und/oder Steuerung der Leuchtmittel bilden, derart, dass einzelne Leuchtmittel einzeln ansteuerbar sind, wobei in einer bevorzugten Ausführungsform die Leuchtmittel auf dem transparenten Substrat in Form einer Punktmatrix zusammengefasst sind.
Daher bezieht sich die Erfindung auch auf ein Element mit Leuchtmitteln, insbesondere Anzeigeelement oder Leuchtvorrichtung umfasssend:
ein Substrat, auf das wenigstens eine TiO₂- Schicht aufgebracht ist sowie eine auf die TiO₂-Schicht aufgebrachte leitfähige Schicht, wobei die leitfähige Schicht eine hochleitende SnO₂ : F-Schicht ist, die der Stromzufuhr zu den Leuchtmitteln dient. Diese Elemente können in den oben erwähnten Großflächenanzeigevorrichtungen eingesetzt werden oder stellen diese selbst dar.

Besonders bevorzugt ist es, wenn die SnO₂ : F-Schicht eines derartigen Elementes eine Leitfähigkeit im Bereich 3 bis 6·10 ⁻⁴ Ohm·cm, insbesondere 5 bis 5,5 ·10⁻⁴ Ohm·cm (Ω·cm) aufweist.

Insbesondere weisen die Elemente SnO₂ : F-Schichten mit einer Dicke im Bereich 200 nm bis 2000 nm, insbesondere im Bereich 500 nm bis 600 nm auf.

Besonders bevorzugt ist es, wenn die TiO₂-Schicht derartiger Elemente eine Dicke im Bereich 5 nm bis 50 nm aufweisen.

Die Erfindung soll nunmehr anhand der Ausführungsbeispiele und der Figuren beschrieben werden. Es zeigen:
- Fig. 1:: Tabelle 1 mit Ausführungs- und Vergleichsbeispielen
- Fig 2a-2b: Reflexionsverläufe im sichtbaren Bereich einer Schicht gemäß Vergleichsbeispiel 3 (Figur 2a) und einer erfindungsgemäßen Schicht (Figur 2b)
- Fig.3a-3b: REM-Aufnahmen zur Morphologie einer Schicht gemäß Vergleichsbeispiel 3 (Figur 3a) und einer erfindungsgemäßen Schicht (Figur 3b)
- Fig.4a-4b: TOF-SIMS-Diagramme einer Schicht gemäß Vergleichsbeispiel 3 (Figur 4a) und einer erfindungsgemäßen Schicht (Figur 4b)
- Figur 5: Beispiel für ein Element mit einer Leiterbahn aus der hochleitfähigen Schicht und Leuchtmitteln

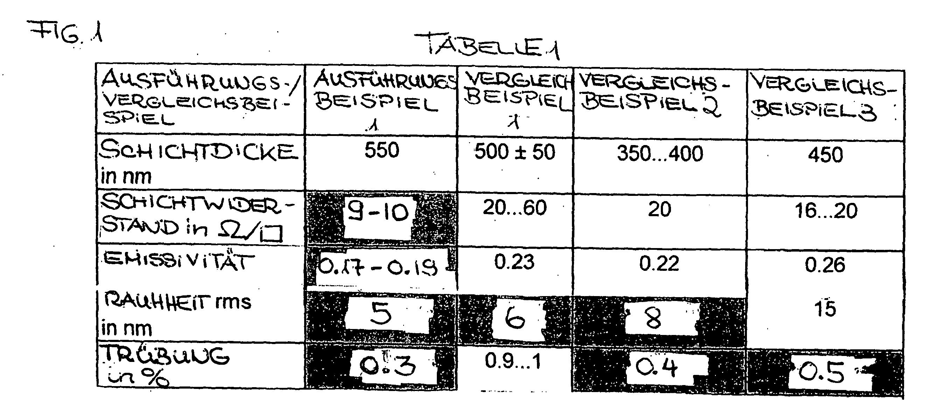

In Figur 1 sind für die hochleitfähigen Schichten gemäß der Erfindung, die auf ein transparentes Substrat aufgebracht werden können, die Werte für die Ausführungsbeispiele sowie für diverse Vergleichsbeispiele 1 bis 3 angegeben. Bei der erfindungsgemäßen hochleitenden Schicht gemäß Ausführungsbeispiel 1 handelt es sich um ein System:
transparentes Substrat / TiO₂ / SnO₂ : F, wobei die Schichtdicke für die TiO₂-Schicht bei 20 nm und die Schichtdicke der SnO₂ : F-Schicht bei 550 nm liegt und das System eine Emissivität von 0,17 aufweist. Als transparentes Substrat wurde Kalk-Natron-Glas mit einer Dicke von 4 mm verwandt. Der Schichtwiderstand dieses erfindungsgemäßen hochleitenden Systems betrug zwischen 9 und 10 Ohms/square. Die Leitfähigkeit liegt des Systems liegt im Bereich 5 bis 5,5·10 ⁻⁴ Ohm·cm.

Im Gegensatz zu den Vergleichsbeispielen mit Schichtdicken in ähnlichen Bereichen zeichnet sich, wie aus Tabelle 1 hervorgeht, das erfindungsgemäße Ausführungsbeispiel 1 durch einen sehr niedrigen Schichtwiderstand aus. Insbesondere gilt dies auch im Vergleich zur leitenden Schicht des Vergleichsbeispieles 3. Die leitfähige Schicht des Vergleichsbeispieles 3 findet z. B. Anwendung bei transparenten Substraten mit leitfähigen Schichten gemäß EP 1450416. Sie weist einen hohen Schichtwiderstand von 16 bis 20 Ohms/square bei einer Dicke von 450 nm auf. Die Leitfähigkeit einer solchen Schicht liegt im Bereich 7 bis 9·10 ⁻⁴ Ohm·cm.

Durch die Verwendung von hochleitfähigen Schichten gemäß dem Ausführungsbeispiel 1, können bei gleicher Schichtdicke aufgrund des geringeren Schichtwiderstandes die Bahnen im Vergleich zu Vergleichsbeispiel 3 bei gleichen Wärmeverlusten wesentlich schmaler ausgeführt werden. Die schmalere Ausführung erlaubt es, die Packung der Leuchtmittel auf dem transparenten Substrat zu erhöhen. Ist die Packung gleich dicht wie im Fall der leitfähigen Schicht gemäß Vergleichsbeispiel 3, so können durch die Verwendung der erfindungsgemäßen hochleitfähigen Schicht gemäß Ausführungsbeispiel 1 die Wärmeverluste vermindert werden. Hierdurch ist es möglich ein Ablösen der hochleitfähigen Schicht, beispielsweise von dem Substrat aufgrund von Wärme oder Verfärbungen zu vermeiden. Der Flächenwiderstand liegt bei einer Schichtdicke im Bereich 9-10 Ohms/square und die Leitfähigkeit im Bereich 5 bis 5,5 10 ⁻⁴ Ohm·cm.

Des Weiteren weist das System gemäß dem Ausführungsbeispiel 1 noch eine ausreichende Transmission im Bereich von ≥ 80 % für sichtbares Licht auf, so dass diese Schicht im Sinne der Anmeldung als transparente Schicht bezeichnet wird.

Überraschenderweise hat sich herausgestellt, dass die hochleitfähigen Schichten gemäß Ausführungsbeispiel 1 sehr gut verspiegelt werden können, beispielsweise in dem man sie mit einem Metall wie Silber oder Chrom oder einem Mehrfachschichtsystem aus derartigen Metallen beschichtet. Die Transmissivitäten der hochleitfähigen Schichten werden dadurch zwar reduziert, jedoch kann man sehr niedrige Schichtwiderstände von wenigern als 8 Ohms/square, insbesondere weniger als 3 Ohms/square, insbesondere im Bereich von 2 Ohms/square mit derartigen Systemen bei Schichtdicken von ungefähr 500 nm realisieren.

Beispiel für ein Metallschichtsystem, das auf die hochleitfähigen Schichten aufgebracht werden kann, ist ein Metallschichtsystem aus Cr/Ag/Cr, wobei die Schichtdicke von Cr im Bereich von 5 bis 15 nm, die Schichtdicke von Ag im Bereich von 20 bis 70 nm und die Schichtdicke von Cr im Bereich von 2 bis 7 nm liegt. Derartige Metallschichtsysteme können nicht nur als Deckschichten oder Unterschichten für die transparent leitfähigen Schichten, sondern auch als Metallschichtsystem, das selbst als Leiterbahn verwendet wird, eingesetzt werden.

Auch dünnere hochleitende Schichtsysteme auf der Basis von ITO-Beschichtungen auf Glas sind denkbar. Beispielsweise können bei einer Schichtdicke von ungefähr 150 bis 200 nm und einer Transmission ≥ 80 % bei einer Wellenlänge von 550 nm Schichten mit einem Schichtwiderstand von ≤ 7 Ohms/square bei einer Schichtdicke von ungefähr 500 nm realisiert werden. Des Weiteren sind Schichten mit einer Schichtdicke von 120 bis 200 nm Schichtdicke möglich, mit einer Transmission im Bereich ≥ 85% bei 550 nm und einem Schichtwiderstand von weniger als 9 Ohms/square.

Erhöht man die Schichtdicken auf 250 bis 300 nm, so kann man mit ITO hochleitfähige Schichtsystemen bei Transmissionen im Bereich von ≥ 80 % bei 550 nm mit Schichtwiderstände < 5 Ohms/square realisieren. Bei Schichtdicken von 400 bis 450 nm ist es möglich mit einer Transmission von ≥ 80 % bei 550 nm Schichtwiderstände von weniger als 4 Ohms/square zu realisieren.

Besonders bevorzugt ist eine hochleitfähiges Schichtsystem gemäß dem Ausführungsbeispiel 1, das auf einem transparenten Substrat, insbesondere einem Glassubstrat, insbesondere Kalk-Natron-Glas folgenden Aufbau hat:
transparentes Substrat / TiO₂ / SnO₂ : F,
d.h. zwischen transparentem Substrat und der fluordotierten Zinnoxidschicht wird eine TiO₂ - Zwischenschicht eingebracht. Ein derartiges System zeichnet sich durch einen Leitfähigkeit im Bereich von 5 bis 5,5·10 ⁻⁴ Ohm·cm (Ω·cm) aus. Bei einer Schichtdicke von 550 nm der SnO₂ : F -Schicht wie im Ausführungsbeispiel 1 ergibt sich dann ein Flächenwiderstand R_{□} im Bereich von 9 bis 10 Ohms/square (ohms/□) der SnO₂ : F -Schicht.

Bei dem hochleitenden Schichtsystem mit dem Aufbau:
transparentes Substrat / TiO₂ / SnO₂ : F
gemäß Ausführungsbeispiel 1 liegt die Schichtdicke für die TiO₂ -Schicht bei 20 nm und die Schichtdicke der SnO₂ : F-Schicht bei 550 nm.

Im Gegensatz zu dem Schichtsystem gemäß Ausführungsbeispiel 1 hat das Schichtsystem gemäß Vergleichsbeispiel 3 aus dem Stand der Technik folgenden Schichtaufbau:
transparentes Substrat / SiO₂ / SnO₂ : F
d.h. zwischen transparentem Substrat und der fluordotierten Zinnoxidschicht wird eine SiO₂ - Zwischenschicht eingebracht. Ein derartiges System zeichnet sich durch einen Leitfähigkeit im Bereich von 7 bis 9·10 ⁻⁴ Ohm·cm (Ω·cm) aus. Bei einer Schichtdicke von 450 nm der SnO₂ : F -Schicht wie im Ausführungsbeispiel 1 ergibt sich dann ein Flächenwiderstand R_{□} im Bereich von 16 bis 20 Ohms/square (ohms/□) der SnO₂ : F -Schicht.

Bei dem Schichtsystem gemäß Vergleichsbeispiel 3 mit dem Aufbau:
transparentes Substrat / SiO₂ / SnO₂ : F
liegt die Schichtdicke für die SiO₂-Schicht bei 50 nm und die Schichtdicke der SnO₂ : F-Schicht bei 450 nm.

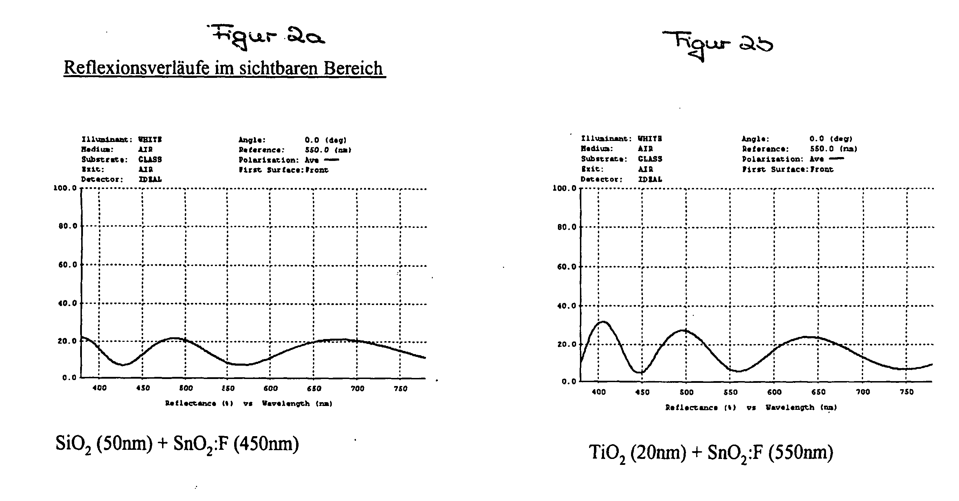

In den Figuren 2a bis 2b sind die Reflektionsverläufe im sichtbaren Wellenlängenbereich für eine Schicht gemäß Vergleichsbeispiel 3 (Figur 2a) und eine erfindungsgemäße Schicht (Figur 2b) gezeigt. Das Reflexionsverhalten der Schichtsysteme ist aufgrund des unterschiedlichen Brechungsindex von SiO₂ (1,47) und TiO₂(2,45) unterschiedlich.

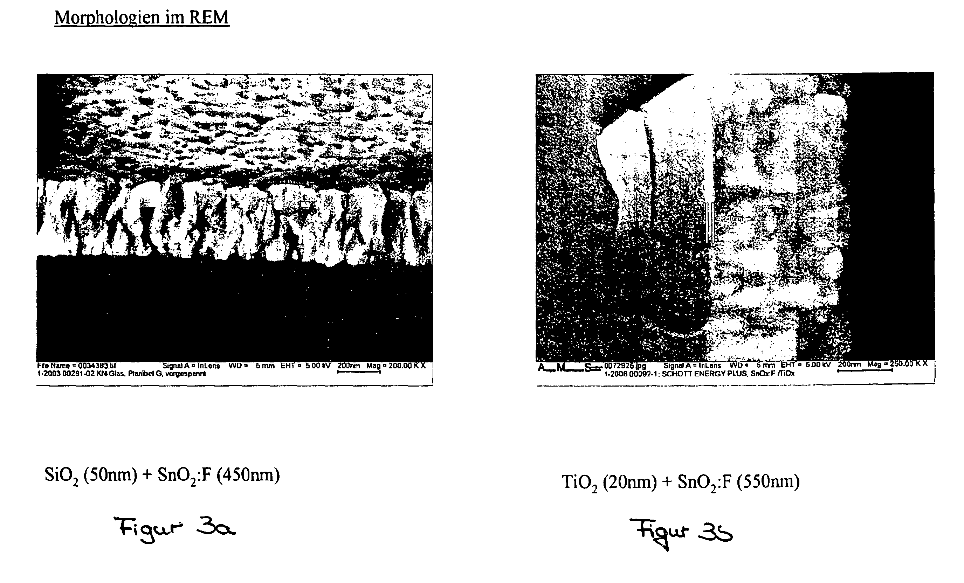

Figuren 3a und 3b zeigen REM-Aufnahmen die gut die unterschiedliche Morphologie der Schicht gemäß Vergleichsbeispiel 3 (Figur 3a) und einer erfindungsgemäßen Schicht (Figur 3b) zeigen.

Wie aus Figur 3a zu erkennen findet man bei dem System gemäß Vergleichsbeispiel 3 mit SiO₂ eine klare kolumnare Struktur der SnO₂:F-Schicht, welche auf dem SiO₂ aufwächst. Das REM kann den Unterschied zwischen SiO₂ Schicht und Substrat aufgrund der amorphen Struktur nicht eindeutig unterscheiden.

Im Gegensatz hierzu wächst wie die REM-Aufnahme in Figur 3b zeigt auf dem TiO₂ das SnO₂:F Schichtsystem mit gröberer Morphologie auf. Verantwortlich dafür ist das TiO₂, welches nicht amorph wie z.B. SiO₂ auf das Substrat aufwächst, sondern in kristalliner Form vorliegt, mit hoher Wahrscheinlichkeit in der anatasen Phase. Das Aufbringen des Schichtsystems auf das Substrat kann mittels APCVD Verfahren bei Temperaturen von größer 500° C erfolgen, was zu einer anatasen Phase des TiO₂ führt. Durch die gröbere Struktur der SnO₂:F-Schicht ändern sich deren elektrischen Eigenschaften. Insbesondere werden in der SnO₂:F-Schicht die mittlere freie Weglänge und die Ladungsträgerkonzentration beeinflusst. Durch diese Effekte kann eine Verbesserung der Leitfähigkeit erzielt werden.

Desweiteren ist TiO₂ ein Halbleitermaterial, was dazu führt, dass bei leichter Unterstöchiometrie Valenzelektronen an das SnO₂:F abgeben werden. Diese abgegebenen Elektronen verbessern die Leitfähigkeit ebenfalls.

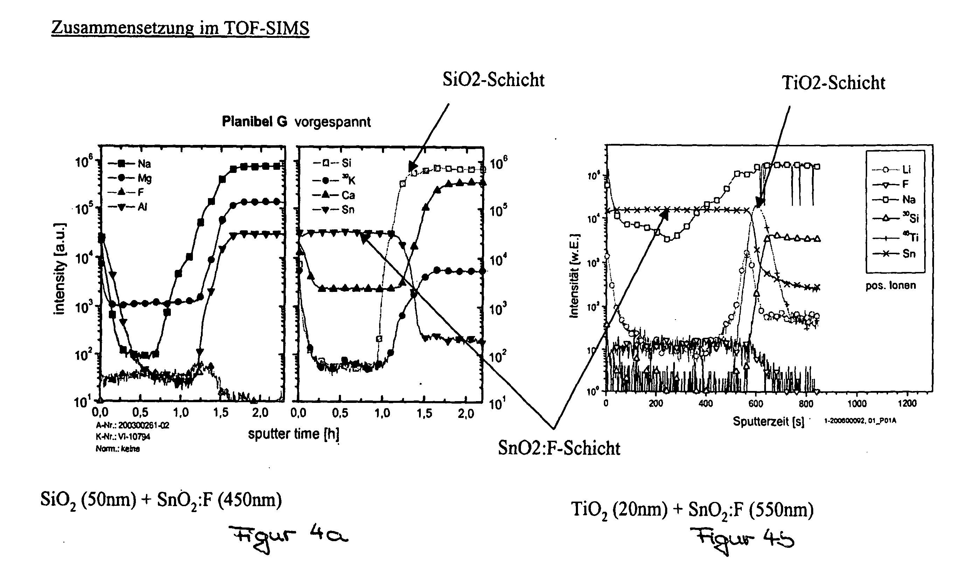

In den Figuren 4a und 4b sind TOF-SIMS-Diagramme einer Schicht gemäß Vergleichsbeispiel 3 (Figur 4a) und einer erfindungsgemäßen Schicht gemäß Ausführungsbeispiel 1 (Figur 4b) gezeigt.

Wie aus diesen TOF-SIMS-Diagrammen hervorgeht fungieren SiO₂ und TiO₂ als Barriereschicht insbesondere gegen Alkaliionen aus dem Substrat. Diffundieren sehr viele Ionen aus dem Substrat in die SnO₂:F Schicht wird generell die Leitfähigkeit verschlechtert. SiO₂ ist gemäß Figur 4a die bessere Barriereschicht, wenn Sie wie im Vergleichsbeispiel 3 gezeigt in einer Schichtdicke von ca. 50nm vorliegt. Das TiO₂ ist wie Figur 4b zeigt vermeintlich die schlechtere Barriereschicht, da mehr Alkaliionen in die SnO₂:F-Schicht eindringen. Hier ist jedoch zu berücksichtigen, dass die TiO₂ -Schicht in Ausführungsbeispiel 1 nur mit ca. 20nm aufgebracht wurde. Eine solch dünne Schicht kann aber auch eine dosierte Ionendiffusion ermöglichen, welche mit freie Ladungsträgern arbeiten, was die Leitfähigkeit zumindest nicht negativ beeinflusst und sogar erhöhen kann.

In der Erfindung wird erstmals ein transparentes Substrat mit einem Schichtsystem angegeben, dass sich durch einen niedrigen Schichtwiderstand auszeichnet. Dieses Schichtsystem erlaubt ein transparentes Substrat mit eng beabstandeten Leiterbahnen, wie sie insbesondere im Bereich von Großflächenanzeigen eingesetzt werden, zu bestücken.

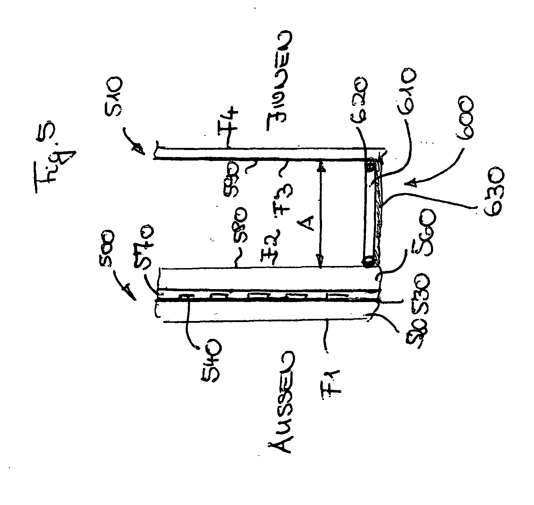

In Figur 5 ist ein Ausführungsbeispiel für eine derartige Großflächenanzeige dargestellt.

Die Goßflächenanzeige umfasst ohne Beschränkung hierauf ein Verbundglaselement 500 sowie einer Monoscheibe 510. Das Verbundglaselement 500 besteht aus einem transparenten Substrat 520 mit darauf aufgebrachter leitfähiger Beschichtung 530 Bei der leitfähigen Beschichtung handelt es sich um eine Beschichtung aus
transparentes Substrat / TiO₂ / SnO₂ : F,
d.h. zwischen transparentem Substrat und der fluordotierten Zinnoxidschicht wird eine TiO₂ - Zwischenschicht eingebracht. Ein derartiges System zeichnet sich durch einen Leitfähigkeit im Bereich von 3 bis 6 ·10⁻⁴ Ohm·cm, insbesondere 5 bis 5,5 10 ⁻⁴ Ohm·cm (Ω·cm) der SnO₂ : F -Schicht aus. Bei einer Schichtdicke von 550 nm der SnO₂ : F -Schicht ergibt sich dann ein Flächenwiderstand R_{□} im Bereich von 5 bis 11 Ohms/square, insbesondere 9 bis 10 Ohms/square (ohms/□) der SnO₂ : F -Schicht.

Bei einem hochleitenden Schichtsystem mit dem Aufbau:
transparentes Substrat / TiO₂ / SnO₂ : F
liegt bevorzugt die Schichtdicke für die TiO₂-Schicht im Bereich 5 nm bis 50 nm, bevorzugt im Bereich 10 nm bis 30 nm und die Schichtdicke der SnO₂ : F-Schicht im Bereich 200 nm bis 2000 nm, insbesondere im Bereich 500 nm bis 600 nm.

Auf der leitfähige Beschichtung 530, die wie oben beschrieben aufgebaut ist, sind Leuchtmittel 540 angeordnet, beispielsweise über Lötpads. Auf der dem Substrat gegenüberliegenden Seite ist eine zweite Scheibe 560 vorgesehen, die das transparente Substrat überdeckt. In den Zwischenraum zwischen transparentem Element mit leitfähiger Schicht und der gegenüberliegenden zweiten Scheibe ist ein Gießharz 570 eingebracht, so dass sich ein Verbundglaselement ergibt. Das Verbundglaselement kann aber auch ein solches sein, bei dem eine Folie, die z. B. die Leuchtmittel tragen kann, zwischen die Scheiben, d.h. das transparente Substrat und die gegenüberliegende zweite Scheibe, eingebracht wird. Die Folie mit Leuchtmitteln ist mit weiteren Folien zwischen die beiden Scheiben einlaminiert. Die weiteren Folien können auch Folien mit speziellen Funktionen, bspw. eine Folie mit Flüssigkristallen sein, die zwischen zwei Zuständen schaltbar ist.

Auch wäre es möglich, einen Teil statt mit einer Folie, die Flüssigkristalle enthält, mit einer Folie zu versehen, die Streukörper umfasst, beispielsweise, um eine Projektionsfläche für eine Auf- oder eine Rückprojektion zur Verfügung zu stellen. Der Abstand A zwischen den Innenflächen 580, 590 der beiden Elemente 500, 510, d.h. hier der Verbundglasscheibe 500 sowie dem Einscheibenelement 510, die das Isolierglaselement 600 ausbilden, liegt zwischen 55 mm, bevorzugt im Bereich zwischen 10 mm und 30 mm, insbesondere bei 16 mm. Der Abstand des Verbundglaselementes und der Monoscheibe wird durch ein Metallstück, bevorzugt aus Aluminium, eingehalten. Das Abstandsstück 610 ist gegenüber den scheibenförmigen Elementen abgedichtet, und zwar mit Hilfe eines Dichtmaterials 620, das bevorzugt aus einem Butylkautschuk besteht. Die vollständige Abdichtung des Zwischenraumes zwischen erstem und zweitem scheibenförmigen Element wird durch unterhalb des Abstandselementes 610 aufgebrachten Butylkautschuk 630 erreicht. Zwischen dem ersten 500 und dem zweiten scheibenförmigen Element 510 befindet sich bevorzugt ein gasförmiges Medium. Bei erhöhten thermischen Anforderungen wird hier insbesondere ein Edelgasmedium eingesetzt. Das Edelgasmedium kann beispielsweise die Elemente Argon oder Xenon oder Krypton umfassen. Des Weiteren sind in Figur 5a die für ein Isolierglaselement typischen Flächen bezeichnet sowie die Seiten, die der Außenseite, d.h. bei der Fassade der Wetterseite hin zugewandt sind sowie der Innenseite, d.h. die Seite, die dem Gebäude zugewandt ist. Das Verbundglaselement, das der Außenseite zugewandt ist, umfasst Flächen F1 und F2, die Monoscheibe, die dem Gebäude zugewandt ist, die Flächen F3 und F4.

Um ein besonders transparentes Element zu erhalten, kann vorgesehen sein, dass z. B. die Fläche F4 mit einer Entspiegelungsschicht versehen ist, beispielsweise wie beim Flachglas AMIRAN®. Auf den Flächen F2 und F3 können Wärmeschutzschichten, beispielsweise Soft Coating, basierend auf Silberschichten oder aber auch Hard Coatings, basierend aus SnOₓ: F oder auch Sonnenschutzschichten aufgebracht sein. Um einen Farbeffekt zu erreichen, kann vorgesehen sein, dass eine Scheibe des Verbundelementes oder die Monoscheibe ein Farbglas ist. Hier wären auch Dekorgläser möglich.

## Patentansprüche

1. Substrat, insbesondere transparentes Substrat mit wenigstens einer leitfähigen Schicht, insbesondere einer Leiterbahn,
**dadurch gekennzeichnet,**
**dass** auf das Substrat wenigstens eine TiO₂- Schicht aufgebracht ist und auf die TiO₂-Schicht eine leitfähige Schicht, wobei die leitfähige Schicht eine hochleitende SnO₂ : F-Schicht ist

2. Substrat gemäß Anspruch 1,
**dadurch gekennzeichnet, dass**
die SnO₂ : f-Schicht eine Leitfähigkeit im Bereich 3 bis 6·10⁻⁴ Ohm·cm, insbesondere 5 bis 5,5·10 ⁻⁴ Ohm·cm (Ω·cm) aufweist.

3. Substrat gemäß einem der Ansprüche 1 bis 2, **dadurch gekennzeichnet, dass** die SnO₂ : F-Schicht eine Dicke im Bereich 200 nm bis 2000 nm, insbesondere im Bereich 500 nm bis 600 nm aufweist.

4. Substrat nach einem der Ansprüche 1 bis 3, **dadurch gekennzeichnet, dass** die TiO₂-Schicht eine Dicke im Bereich 5 nm bis 50 nm aufweist.

5. Substrat gemäß einem der Ansprüche 1 bis 4,
**dadurch gekennzeichnet,**
**dass** auf und/oder unter der hoch leitfähigen Schicht des Weiteren eine Metallschicht angeordnet ist.

6. Substrat gemäß Anspruch 5,
**dadurch gekennzeichnet,**
**dass** die Metallschicht einer oder mehrere der nachfolgenden Elemente umfasst:
Ag
Cr
Au

7. Substrat gemäß einem der Ansprüche 5 bis 6,
**dadurch gekennzeichnet,**
**dass** die Metallschicht eine Dicke im Bereich 2 bis 100 nm, insbesondere 5 bis 60 nm aufweist.

8. Substrat gemäß einem der Ansprüche 1 bis 7,
**dadurch gekennzeichnet,**
**dass** die hochleitfähige Schicht in Form von wenigstens einer Leiterbahn mit wenigstens einem Leuchtmittel verbunden ist.

9. Substrat gemäß Anspruch 8, wobei die Leuchtmittel Leuchtdioden sind.

10. Substrat gemäß einem der Ansprüche 8 bis 9,
**dadurch gekennzeichnet,**
**dass** die Stromversorgung und/oder die Steuerung der Leuchtmittel über die hochleitfähigen Leiterbahnen auf dem transparenten Substrat erfolgt.

11. Substrat gemäß einem der Ansprüche 1 bis 10,
**dadurch gekennzeichnet,**
**dass** das transparente Substrat aus Glas besteht.

12. Substrat gemäß einem der Ansprüche 1 bis 11,
**dadurch gekennzeichnet,**
**dass** das transparente Substrat über Anschlüsse für die Stromversorgung an die hochleitfähigen Schichten verfügt.

13. Substrat gemäß einem der Ansprüche 9 bis 12,
**dadurch gekennzeichnet,**
**dass** die Leuchtdioden RGB-Leuchdioden sind, die mit Hilfe von Ansteuerungen Bilder erzeugen können.

14. Substrat gemäß einem der Ansprüche 1 bis 13,
**dadurch gekennzeichnet,**
**dass** die hochleitfähigen Schichten mehrere Stromkreise zur Stromversorgung und/oder zur Steuerung der Leuchtmittel bilden, derart dass einzelne Leuchtmittel einzeln ansteuerbar sind.

15. Substrat gemäß Anspruch 14,
**dadurch gekennzeichnet,**
**dass** die Leuchtmittel auf dem transparenten Substrat eine Punktmatrix bilden.

16. Element mit Leuchtmitteln, insbesondere Anzeigeelement oder Leuchtvorrichtung umfasssend:
ein Substrat gemäß Anspruch 1, wobei die leitfähige Schicht der Stromzufuhr zu den Leuchtmitteln dient.

17. Element gemäß Anspruch 16,
**dadurch gekennzeichnet, dass** die SnO₂: F-Schicht eine Leitfähigkeit im Bereich 3 bis 6·10 ⁻⁴ Ohm·cm, insbesondere 5 bis 5,5 ·10⁻⁴ Ohm·cm (Ω·cm) aufweist,

18. Element gemäß einem der Ansprüche 16 bis 17,
**dadurch** gekennzeichent, dass die SnO₂ : F-Schicht eine Dicke im Bereich 200 nm bis 2000 nm, insbesondere im Bereich 500 nm bis 600 nm aufweist, 19. Element gemäß einem der Ansprüche 16 bis 18, **dadurch gekennzeichnet, dass** die TiO₂-Schicht eine Dicke im Bereich 5 nm bis 50 nm aufweist.

## Claims

1. Substrate, in particular a transparent substrate having at least one conductive layer, in particular a conductor track,
**characterised in that**
at least one TiO₂ layer is applied to the substrate and a conductive layer to the TiO₂ layer, the conductive layer being a highly conductive SnO₂:F layer.

2. Substrate according to claim 1,
**characterised in that** the SnO₂:F layer has conductivity in the range of 3 to 6·10⁻⁴ Ohm·cm, in particular 5 to 5.5·10⁻⁴ Ohm·cm (Ω·cm).

3. Substrate according to either of claims 1 to 2,
**characterised in that** the SnO₂:F layer has a thickness in the range of 200 nm to 2,000 nm, in particular in the range of 500 nm to 600 nm.

4. Substrate according to any one of claims 1 to 3,
**characterised in that** the TiO₂ layer has a thickness in the range of 5 nm to 50 nm.

5. Substrate according to any one of claims 1 to 4, **characterised in that**
a metal layer is also arranged on and/or below the highly conductive layer.

6. Substrate according to claim 5,
**characterised in that**
the metal layer comprises one of more of the following element(s):
Ag
Cr
Au.

7. Substrate according to either of claims 5 to 6,
**characterised in that**
the metal layer has a thickness in the range of 2 to 100 nm, in particular 5 to 60 nm.

8. Substrate according to any one of claims 1 to 7,
**characterised in that**
the highly conductive layer in the form of at least one conductor track is connected to at least one light source.

9. Substrate according to claim 8, wherein the light sources are light-emitting diodes.

10. Substrate according to either of claims 8 to 9,
**characterised in that**
the light source power supply and/or controller is provided by way of the highly conductive conductor tracks on the transparent substrate.

11. Substrate according to any one of claims 1 to 10,
**characterised in that**
the transparent substrate consists of glass.

12. Substrate according to any one of claims 1 to 11,
**characterised in that**
the transparent substrate has connections for the power supply to the highly conductive layers.

13. Substrate according to any one of claims 9 to 12,
**characterised in that**
the light-emitting diodes are RGB light-emitting diodes which can generate images with the aid of control systems.

14. Substrate according to any one of claims 1 to 13,
**characterised in that**
the highly conductive layers form a plurality of electric circuits for supplying the power to and/or controlling the light sources in such a way that individual light sources can be individually activated.

15. Substrate according to claim 14,
**characterised in that**
the light sources form a dot matrix on the transparent substrate.

16. Element having light sources, in particular a display element or an illumination device, comprising:
a substrate according to claim 1, wherein the conductive layer serves as the power supply to the light sources.

17. Element according to claim 16,
**characterised in that** the SnO₂:F layer has conductivity in the range of 3 to 6·10⁻⁴ Ohm·cm, in particular 5 to 5.5·10⁻⁴ Ohm·cm (Ω·cm).

18. Element according to either of claims 16 to 17,
**characterised in that** the SnO₂:F layer has a thickness in the range of 200 nm to 2,000 nm, in particular in the range of 500 nm to 600 nm.

19. Element according to any one of claims 16 to 18,
**characterised in that** the the TiO₂ layer has a thickness in the range of 5 nm to 50 nm.

## Revendications

1. Substrat, en particulier substrat transparent avec au moins une couche conductrice, en particulier une piste conductrice,
**caractérisé en ce qu'**au moins une couche de TiO₂ est appliquée sur le substrat et une couche conductrice sur la couche de TiO₂, la couche conductrice étant une couche de SnO₂:F à haute conductivité.

2. Substrat selon la revendication 1, **caractérisé en ce que** la couche de SnO₂:F présente une conductivité comprise entre 3 et 6 × 10⁻⁴ ohms/cm, en particulier entre 5 et 5,5 × 100⁻⁴ ohms/cm (Ω/cm).

3. Substrat selon l'une des revendications 1 à 2, **caractérisé en ce que** la couche de SnO₂:F présente une épaisseur comprise entre 200 nm et 2000 nm, en particulier entre 500 nm et 600 nm.

4. Substrat selon l'une des revendications 1 à 3, **caractérisé en ce que** la couche de TiO₂ présente une épaisseur comprise entre 5 nm et 50 nm.

5. Substrat selon l'une des revendications 1 à 4, **caractérisé en ce qu'**une couche métallique est en outre disposée sur et/ou sous la couche à haute conductivité.

6. Substrat selon la revendication 5, **caractérisé en ce que** la couche métallique contient un ou plusieurs des éléments suivants :
Ag
Cr
Au.

7. Substrat selon l'une des revendications 5 à 6, **caractérisé en ce que** la couche métallique présente une épaisseur comprise entre 2 et 100 nm, en particulier entre 5 et 60 nm.

8. Substrat selon l'une des revendications 1 à 7, **caractérisé en ce que** la couche à haute conductivité est connectée à au moins une lampe sous la forme d'au moins une piste conductrice.

9. Substrat selon la revendication 8, dans lequel les lampes sont des diodes électroluminescentes.

10. Substrat selon l'une des revendications 8 à 9, **caractérisé en ce que** l'alimentation électrique et/ou la commande des lampes passent par les pistes conductrices à haute conductivité sur le substrat transparent.

11. Substrat selon l'une des revendications 1 à 10, **caractérisé en ce que** le substrat transparent est composé de verre.

12. Substrat selon l'une des revendications 1 à 11, **caractérisé en ce que** le substrat transparent possède des connexions sur les couches à haute conductivité pour l'alimentation électrique.

13. Substrat selon l'une des revendications 9 à 12, **caractérisé en ce que** les diodes électroluminescentes sont des diodes RVB, qui peuvent produire des images à l'aide de commandes.

14. Substrat selon l'une des revendications 1 à 13, **caractérisé en ce que** les couches à haute conductivité forment plusieurs circuits électriques pour l'alimentation électrique et/ou la commande des lampes, de sorte que différentes lampes peuvent être commandées séparément.

15. Substrat selon la revendication 14, **caractérisé en ce que** les lampes forment une matrice de points sur le substrat transparent.

16. Élément équipé de lampes, en particulier élément d'affichage ou dispositif d'éclairage, comprenant un substrat selon la revendication 1, dans lequel la couche conductrice sert à l'alimentation électrique des lampes.

17. Élément selon la revendication 16, **caractérisé en ce que** la couche de SnO₂:F présente une conductivité comprise entre 3 et 6 × 10⁻⁴ ohms/cm, en particulier entre 5 et 5,5 × 10⁻⁴ ohms/cm (Ω/cm).

18. Élément selon l'une des revendications 16 à 17, **caractérisé en ce que** la couche de SnO₂:F présente une épaisseur comprise entre 200 nm et 2000 nm, en particulier comprise entre 500 nm et 600 nm.

19. Élément selon l'une des revendications 16 à 18, **caractérisé en ce que** la couche de TiO₂ présente une épaisseur comprise entre 5 nm et 50 nm.
